# EUROPEAN PATENT APPLICATION

(11) **EP 0 685 436 A1**
(43) Date of publication of application: **06.12.1995**
(21) Application number: 95303502.9
(22) Date of filing: 24.05.1995
(51) Int. Cl.: C04B 35/468, H01B 3/12, H01L 23/66

(54) **Ceramic substrates for hybrid integrated circuits**

(30) Priority: 02.06.1994 US 252796
(71) Applicant: AT&T Corp., New York, NY 10013-2412 (US)
(72) Inventor: O'Bryan, Henry Miles, Jr., Plainfield, New Jersey 07060 (US); Rhodes, Warren William, Raritan, New Jersey 08869 (US)
(74) Representative: Johnston, Kenneth Graham

(57) **Abstract**

Disclosed is a process for fabricating thin Ba₂ Ti₉ O₂₀ ceramic substrates suitable for use in radio frequency modules with thin film metallizations. Formation of a nearly, single phase ceramic with 98.5% density (4.56 g cm³), high loss quality and smooth surface is assured by prereacting precursor powders at temperatures within a range of from 1020°C to 1090°C, preferably from 1030°C to 1075°C, most preferably from 1045°C to 1075°C, forming the preacted powders into a desired form and sintering the forms of prereacted powders at temperatures ranging from 1330°C to 1350°C, preferably from 1340°C to 1350°C. Ba₂ Ti₉ O₂₀ compositions which have a slight TiO₂ excess are found to be smoother than compositions which are stoichiometric or Ba excess. Substrates made from such powders have fewer surface defects than powders prereacted at temperatures above 1075°C. The lower sintering temperature also reduces the possibility of substrate/setter reactions.

## Description

### Field of the Invention

This invention concerns ceramic substrates for hybrid integrated circuits.

### Background of the Invention

Large thin ceramic substrates are needed for use in radio frequency modules. The technology of these modules (stripline) utilizes printed circuits on a high dielectric constant substrate in order to reduce the circuit dimensions, lower costs and simplify designs. When used as a passive support for thin films, the physical properties of the ceramic substrate, e.g., surface roughness, electrical resistivity, thermal conductivity and density, are important. The surface roughness affects the uniformity of the thin film conductors while high electrical resistivity is required to prevent leakage currents or short circuits. Adequate thermal conductivity prevents temperature excursions which can cause device deterioration while high density promotes flexural strength.

Conventionally used Al₂O₃ substrates on which are mounted thin film circuits (FIC process) or hybrid integrated circuits (HIP process) provide inert strong platforms which have high thermal conductivity and high electrical resistivity. However, the moderately low dielectric constant (k ∼ 9.6) has a limited effect on circuit performance. When intended for use in stripline, the ceramic should have a high dielectric constant so that the interaction between conductors is strong. Ba₂ Ti₉ O₂₀ ceramics have been used for resonators because of their combination of high dielectric constant, k = 40, low microwave loss, Q = 10000 at 4 GHz, and a temperature-stable dielectric constant. What is needed to make useful substrates from this ceramic is a smooth surface which is free of defects and large grains.

### Summary of the Invention

This invention embodies thin Ba₂ Ti₉ O₂₀ ceramic substrates for use in radio frequency modules with thin film metallizations. Formation of a nearly single phase ceramic with 98.5% density (4.56 g/cm³), high loss quality and smooth surface is assured by prereacting precursor powders at temperatures within a range from 1020°C to 1090°C, preferably from 1030°C to 1075°C, most preferably from 1045°C to 1075°C, forming the prereacted powders into a desired form and sintering the forms of prereacted powders at temperatures ranging from 1330°C to 1350°C, preferably from 1340°C to 1350°C. Ba₂ Ti₉ O₂₀ compositions which have a slight TiO₂ excess are found to be smoother than compositions which are stoichiometric or Ba excess. Substrates made from such powders have fewer surface defects than powders prereacted at temperatures above 1075°C. The lower sintering temperature also reduces the possibility of substrate/setter reactions.

### Brief Description of the Drawing

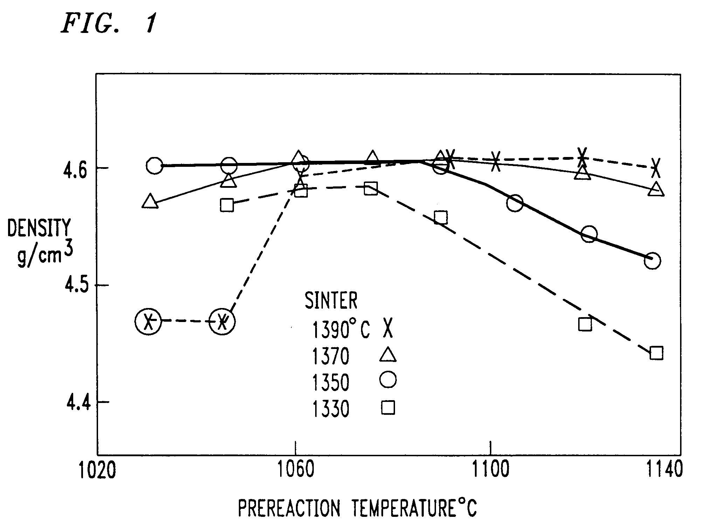

FIG. 1 discloses a plot of Sintered Density vs Prereaction Temperature for powders sintered at from 1330° to 1390°C; circled points have large grains of BaTi₄ O₉ as a major phase.

### Detailed Description of the Invention

Large Ba₂ Ti₉ O₂₀ ceramic substrates are being considered for use in radio frequency modules. Thicknesses within a range of from 0.010 to 0.080 inches, preferably from 0.025 to 0.030 inches are contemplated. The substrates are required to meet certain dielectric, strength, thickness and smoothness specifications. To meet the dielectric specifications, the density of the Ba₂Ti₉ O₂₀ ceramic must be uniform while adequate strength is obtained when the density is at least 4.56g/cm³. To achieve this density, conventional powder processing requires the use of a high prereaction temperature of from 1135 to 1145°C and a high sintering temperature of about 1390°C. Conventionally, BaTiO₃ and TiO₂ powders have been prereacted at 1100°C to 1150°C for at least 6 hours (h) and sintered at 1380°C to 1390°C for 6h in oxygen to obtain ceramic suitable for resonators.

One problem which has been encountered in the conventional process of preparing relatively thin (0.025-0.030 in) Ba₂ Ti₉ O₂₀ substrates, is the reaction between the Ba₂ Ti₉ O₂₀ ceramic and setters (ceramic supports) holding the substrates during sintering. Such reactions produce defects on the substrate surface at places of contact with the ceramic supports or with cover weights. A second type of defect, large surface grains, which have diameters and/or depths ≧0.002 in., also interferes with thin film metallization having conductors with line widths of ≧0.004 in. and a thickness of ∼0.0003 in. This latter defect occurs when BaTi₄ O₉ grains grow rapidly either because of improper prereaction or improper cation stoichiometry.

Ba₂ Ti₉ O₂₀ is one of several Ba-Ti-O compounds which form when BaCO₃ and TiO₂ or BaTiO₃ and TiO₂ react at high temperature. If the starting powders are well mixed and properly proportioned, the distribution of compounds in the prereacted powder depends on the temperature and time of heating. Besides Ba₂ Ti₉ O₂₀ other phases are formed during prereaction which include Ba₄ Ti₁₃ O₃₀, BaTi₄ O₉ and BaTi₅ O₁₁. Unless at least 15% of Ba₂ Ti₉ O₂₀ phase is formed during the prereaction, sintering will not yield a dense, nearly single phase Ba₂ Ti₉ O₂₀ ceramic with high loss quality. This situation results from the slower kinetics of formation for Ba₂ Ti₉ O₂₀ relative to BaTi₄ O₉ and the rapid grain growth of BaTi₄ O₉ during both the prereaction and sintering steps. Once formed as large grains, BaTi₄ O₉ is relatively stable and tends to concentrate at the fired surface where it increases surface roughness.

In previous Ba-Ti-O ceramics processing, e.g., for use of Ba₂ Ti₉ O₂₀ as a low loss, high dielectric resonator ceramic, the objective was to form ceramics with mechanical stability, a very high loss quality and a low temperature coefficient of resonant frequency. These objectives were attained by careful control of cation stoichiometry, the use of high purity raw materials, and processing for high density, complete oxidation and suppression of TiO₂ second phase. A high sintering temperature, i.e., of the order of 1390°C, was required to produce such ceramic. Low temperature prereaction which yielded powders without some Ba₂ Ti₉ O₂₀ did not produce suitable resonator ceramic. These ceramics often contained a significant amount of BaTi₄ O₉ second phase which lowered the dielectric constant, and increased the temperature coefficient. When the sintering temperature was reduced to prevent BaTi₄ O₉ formation, density and loss quality decreased.

For the use of Ba₂ Ti₉ O₂₀ substrates in the radio frequency modules, intrinsic loss quality is not as important since the substrates have metallized surfaces rather than being unmetallized. Also, whereas in resonator ceramics, compositions with Ba excess were required to avoid microcracking in thin substrates, we have discovered that there is no dependence on stoichiometry in the radio frequency module substrates: the thin cross section (0.010 to 0.080 in.) of the substrate reduces both the need for reoxidation and a tendency to micro-crack. We have also discovered that if the prereaction temperature is reduced to a range wherein sufficient reactivity is retained, the lower prereaction temperature permits a lower sintering temperature and produces an improved ceramic substrate. Reducing the sintering temperature will also reduce the degree of substrate/setter reaction. Secondary effects should be improved flatness and smoother surfaces since lower temperatures reduce distortions such as warpage or cracking and produce smaller surface grains. The applicants have discovered that prereaction temperatures within a range of from 1020 to 1090°C, preferably within a range of from 1030 to 1075°C, followed by sintering at temperatures ranging from 1330 to 1350°C, permits production of thin substrates with high density (≧4.55g/cm³) and smooth surface. Compositions having a slight excess of TiO₂ led to smoother surfaces than compositions which are stoichiometric or have Ba excess.

Powder suitable for making substrates is prepared from well mixed BaTiO₃ + TiO₂. The batching formula was BaTiO₃ + 3.5x TiO₂ where the x is from 1.001 to 1.01. The x value was experimentally determined to yield, upon sintering, a ceramic with a slight amount of TiO₂ second phase. Large x values are not desired because of large temperature coefficients of capacitance. The mixed powder was prereacted at temperatures within a range of 1030 to 1075°C for 6 hours.

After milling the prereacted powder in water with 1/2 inch ZrO₂ media for 5h, the powder was dried and granulated. A heating at 900°C in air for a period sufficient to remove any plastic inclusions was followed by forming the prereacted powder into various shapes and sizes. Various methods of forming thin shapes can be used with these powders, e.g., pressing, tape casting, or roll compaction. Sintering was at 1330°C to 1390°C for 6h in oxygen.

Grain size was measured on polished disks or coupons, thermally etched at 1150°C, and density was obtained by an immersion method. The microstructure of sections of polished disks was examined optically both before and after thermal etching for evidence of second phase. Surface roughness was measured with a profilometer (Dectak II, Veeco Corp.) on a 2 mm trace with a 12 µm diameter stylus. The presence (or absence) of microcracks which cause unstable dielectric properties was determined by dye staining.

The effect of prereaction and sintering temperatures on sintered density is shown in FIG. 1. For density >4.55 g/cm³ powder prereacted at ≦1045°C must be sintered below 1370°C while powders prereacted at 1135°C must be sintered above 1350°C. Prereaction at from 1030°C to 1075°C yields the powder which attains the highest density for 1350°C sintering. Conditions which produce second phases are indicated by a special symbol( a large circle).

Table I compares the density and surface roughness of substrate coupons (1 × 1 × .027 in) made from powders prereacted at 1135°C, 1100°C and 1075°C and sintered at temperatures within a range of from 1330°C to 1400°C. For similar density, less surface roughness is obtained for high density ceramic made with the powder prereacted at the lower temperature.

**Table I**

| **Substrate Properties** | | | | | | |
|---|---|---|---|---|---|---|
| | Prereaction Temperature | | | | | |
| Sinter °C | 1135°C | | 1100°C | | 1075°C | |
| | Density | Ra | Density | Ra | Density | Ra |
| 1400 | 4.603g/cm³ | 52 µ in | | | | |
| 1390 | 4.595 | 44 | 4.599 | 52 | | |
| 1380 | 4.588 | | | | | |
| 1370 | 4.572 | 34 | | | 4.598 | 36 |
| 1350 | 4.539 | 31 | 4.588 | 30 | 4.598 | 28 |
| 1340 | 4.498 | | 4.567 | 31 | | |
| 1330 | | | 4.548 | 23 | 4.569 | 21 |

The microstructure of ceramics obtained from the prereacted powders are usually > 95% Ba₂ Ti₉ O₂₀ phase. The exceptions are those obtained from powders prereacted at ≦1045°C and sintered at ≧1370°C. These temperatures favor BaTi₄ O₉ grain growth and very large BaTi₄ O₉ grains (∼500 µm × 100 µm) are found in a matrix of small Ba₂ Ti₉ O₂₀ and TiO₂ grains. The grain size of Ba₂ Ti₉ O₂₀ increases with sintering temperature from 3-5 µm at 1330°C to 10-15 µm at 1390°C for powders prereacted at ≧1090°C.

Additional advantages and modifications will readily occur to those skilled in the art. Therefore, the invention in its broader aspects is not limited to the specific details, representative devices, and illustrated examples shown and described. Accordingly, various modifications may be made without departing from the spirit or scope of the general inventive concept as defined by the appended claims and their equivalents.

## Claims

1. A process of fabricating Ba₂ Ti₉ O₂₀ ceramic substrates, which comprises
prereacting precursor materials comprising TiO₂ and at least one of BaCO₃ and BaTiO₃, forming the prereacted material into a desirable thin form, and sintering the formed prereacted material, wherein
to ensure formation of high density substrates with smooth surface, said prereacting is conducted at temperatures ranging from 1020°C to 1090°C, and said sintering is conducted at temperatures ranging from 1330 to 1350°C.

2. The process of claim 1, in which said precursor materials are BaTiO₃ and TiO₂.

3. The process of claim 2 in which the precursor materials are combined according to a batching formula
BaTiO₃ + 3.5x TiO₂, wherein x is between 1.001 and 1.01 percent.

4. The process of claim 1, in which said prereacting temperature ranges from 1045 to 1075°C.

5. The process of claim 1, in which said sintering temperature ranges from 1340°C to 1350°C.

6. The process of claim 1, in which said thin form has a thickness ranging from 0.010 to 0.080 inches.

7. The process of claim 1, in which said thick form has a thickness ranging from 0.025 to 0.030 inches.

8. The process of claim 1, in which the roughness of the surface of the sintered form is less than 30µ inches.

9. A Ba₂ Ti₉ O₂₀ substrate fabricated by the method of claim 1, in which said substrate has a density of greater than 4.55 gm/cm² and a roughness of the major surface of the substrate less than 30µ inches.
